# EUROPÄISCHE PATENTSCHRIFT

(11) **EP 1 984 750 B1**
(45) Veröffentlichungstag und Bekanntmachung des Hinweises auf die Patenterteilung: **17.07.2019**
(21) Anmeldenummer: 06705907.1
(22) Anmeldetag: 01.02.2006
(51) Int. Cl.: G01R 31/28, H02H 3/00

(54) **VERFAHREN UND ANORDNUNG ZUM TESTEN EINES DIGITALE ABTASTDATEN VERARBEITENDEN SCHUTZGERÄTS**
METHOD AND ARRANGEMENT FOR TESTING A PROTECTIVE DEVICE PROCESSING DIGITAL SAMPLING DATA
PROCÉDÉ ET DISPOSITIF PERMETTANT DE TESTER UN APPAREIL DE PROTECTION TRAITANT DES DONNÉES ÉCHANTILLONNÉES NUMÉRIQUES

(30) Priorität: 12.01.2006 WO PCT/DE2006/000052
(43) Veröffentlichungstag der Anmeldung: 29.10.2008
(73) Patentinhaber: Siemens Aktiengesellschaft, 80333 München (DE)
(72) Erfinder: LANG, Gerhard, 14557 Wilhelmshorst (DE); SCHUSTER, Norbert, 90584 Allersberg (DE); SCHWABE, Stefan, 10589 Berlin (DE); WENZEL, Volker, 16540 Hohen Neuendorf (DE)
(86) Internationale Anmeldenummer: PCT/DE2006/000179
(87) Internationale Veröffentlichungsnummer: WO 2007/079702

(56) Entgegenhaltungen:
- US-A1- 2002 173 927
- KEZUNOVIC ET AL.: "TROUBLESHOOTING PROTECTIVE RELAY OPERATIONS USING FIELD RECORDED WAVEFORMS" IEEE, [Online] 19. Juni 2002 (2002-06-19), Seiten 1-6, XP002394849 Montreal Gefunden im Internet: URL:http://www.ipst.org/TechPapers/2005/IP ST05_Paper221.pdf> [gefunden am 2006-08-15]
- RYAN B ET AL: "SYNCHRONIZED, END-TO-END TESTS ON PROTECTIVE RELAY SCHEMES" IEEE COMPUTER APPLICATIONS IN POWER, IEEE INC. NEW YORK, US, Bd. 8, Nr. 4, 1. Oktober 1995 (1995-10-01), Seiten 20-25, XP000549848 ISSN: 0895-0156
- RYAN B: "The use of digital fault recorder records and other transient waveform records in tests on protection relays" DEVELOPMENTS IN POWER SYSTEM PROTECTION, SIXTH INTERNATIONAL CONFERENCE ON (CONF. PUBL. NO. 434) NOTTINGHAM, UK 25-27 MARCH 1997, LONDON, UK,IEE, UK, 25. März 1997 (1997-03-25), Seiten 398-401, XP006508013 ISBN: 0-85296-672-5
- "Doble Protection Testing Software Program"[Online] September 2004 (2004-09), Seiten 1-6, XP002394850 Gefunden im Internet: URL:http://www.doble.com/content/products/ ProTesT_Software_Brochure.pdf> [gefunden am 2006-08-14]

## Beschreibung

Die Erfindung bezieht sich auf ein Verfahren zum Testen eines Feldgerätes, wobei das Feldgerät eine Vielzahl von analogen Eingängen zum Einspeisen eines analogen Messsignals aufweist, das sich auf eine zu überwachende elektrotechnische Anlage bezieht, eine externe Kommunikationsschnittstelle zum Einspeisen digitaler Messsignale aufweist, und eine mit den analogen Eingängen jeweils über eine A/D-Wandlereinheit und jeweilige digitale Signaleingänge und mit der externen Kommunikationsschnittstelle in Verbindung stehende digital arbeitende Auswerteinrichtung aufweist, die im Falle eines Anliegens des eingangsseitigen analogen Messsignals dieses auswertet und ein Fehlersignal erzeugt, falls das Messsignal auf einen Fehler in der zu überwachenden elektrotechnischen Anlage hindeutet.

Ein Schutzgerät für Energieübertragungssysteme wird beispielsweise von der Siemens AG unter dem Produktnamen SIPROTEC vertrieben. Bei diesem Schutzgerät lässt sich die Arbeitsweise des Schutzgerätes von außen über einen Netzwerk- bzw. Datenbus-Anschluss verändern, indem eine Neu-Parametrierung des Gerätes vorgenommen wird. Während des Betriebs des vorbekannten Schutzgeräts werden digitale Abtastdaten in das Schutzgerät eingespeist und ausgewertet. Falls das Schutzgerät bei dieser Auswertung feststellt, dass die Abtastdaten einen Fehler anzeigen, wird ein Fehler- bzw. Alarmsignal erzeugt.

Aus der US 2002/0173927 A1 ist ein Testsystem bekannt, bei dem ein oder mehrere intelligente elektronische Geräte mit einem separaten Testgerät geprüft werden können.

Ein weiteres Testsystem ist auch aus dem Artikel "Troubelshooting protective relay operations using field recorded waveforms", Kezunovic et al, International Conference on Power Systems Transients in Montreal, June 19-23, 2005 bekannt.

Der Erfindung liegt die Aufgabe zugrunde, ein Verfahren anzugeben, mit dem sich digitale Abtastdaten verarbeitende Schutzgeräte besonders einfach auf ihre Funktionstüchtigkeit testen lassen.

Diese Aufgabe wird erfindungsgemäß durch die Merkmale des Anspruchs 1 gelöst. Vorteilhafte Ausgestaltungen des erfindungsgemäßen Verfahrens sind in Unteransprüchen angegeben.

Danach ist erfindungsgemäß vorgesehen, dass eine mit der Auswerteinrichtung einerseits und mit der eine mit der Auswerteinrichtung einerseits und mit der externen Kommunikationsschnittstelle andererseits in Verbindung stehende geräteinterne Prüfeinrichtung des Feldgerätes ein digitales Testsignal selbst erzeugt und die geräteinterne Prüfeinrichtung nach einem Starten eines Testmodus das digitale Testsignal als Messsignal in die Auswerteinrichtung zum Testen des Feldgerätes einspeist, wobei über die externe Kommunikationsschnittstelle externe Störwertaufzeichnungen in die Prüfeinrichtung übertragen werden und die geänderte Prüfeinrichtung mit den Störwertaufzeichnungen die digitalen Testsignale erzeugt, indem sie mit den Daten der externen Störwertaufzeichnung digitale Abtastwerte bildet, die während der Störwertaufzeichnung aufgenommenen Wandlerdaten zumindest eines Wandlers entsprechen, und diese zum Test des Feldgerätes heranzieht, und wobei die geräteinterne Prüfeinrichtung beim Durchführen des Testmodus das an die Auswerteeinrichtung angelegte Testsignal sowie die entsprechende Reaktion des Feldgerätes darauf in Form eines Störschriebes abspeichert.

Unter dem Begriff Netzwerk werden nachfolgend alle Arten von Datenverbindungen verstanden, insbesondere externe Datenverbindungen (beispielsweise in Form eines externen Datenbusses, eines externen Ethernet-Netzwerkes oder des Internets) oder interne Datenverbindungen (interner Datenbus innerhalb eines Gerätes oder einer Geräteanordnung, interne Netzwerke innerhalb eines Gerätes oder einer Geräteanordnung).

Ein wesentlicher Vorteil des erfindungsgemäßen Feldgerätes besteht darin, dass dieses einen Gerätetest mit einem sehr geringen Aufwand ermöglicht, da nämlich erfindungsgemäß eine Prüfeinrichtung zum Testen des Feldgerätes bereits in diesem integriert ist. Es ist somit nicht erforderlich, zunächst eine separate Prüfeinrichtung zu beschaffen, was zusätzliche Kosten verursachen würde, und diese an das Feldgerät anzuschließen, bevor ein Testen des Feldgerätes möglich ist.

Ein weiterer wesentlicher Vorteil des erfindungsgemäßen Feldgerätes ist darin zu sehen, dass dieses zum Testen unmittelbar digitale Testsignale verwendet. Dies ermöglicht es, die in der Auswerteinrichtung implementierten digitalen Prüfalgorithmen zu testen, ohne dass Wandlerfehler, die beim Umwandeln eines analogen Testsignals in ein digitales Testsignal auftreten könnten, das Testergebnis verfälschen. Es lässt sich somit allein die Funktionsweise der Auswerteinrichtung testen, ohne dass ein Wandlereinfluss zu berücksichtigen ist.

Ein weiterer Vorteil des erfindungsgemäßen Verfahrens ist darin zu sehen, dass das Schutzgerät unter Heranziehung beliebiger Störwertaufzeichnungen getestet werden kann; erfindungsgemäß erfolgt der Test des Schutzgeräts nämlich nicht mit physikalisch tatsächlich "neu" erzeugten Wandlersignalen, sondern stattdessen mit "konservierten" Signalverläufen, die zu beliebigen früheren Zeitpunkten von beliebigen elektrischen Wandlern gebildet worden sind. Die Durchführung des erfindungsgemäßen Verfahrens erfordert somit im Vergleich zu einem Verfahren, bei dem "echte" Wandlerdaten verwendet werden, deutlich weniger Geräte- bzw. Hardwareaufwand; denn die Wandlerdatenerzeugung erfolgt ausschließlich softwaremäßig unter Heranziehung von "alten", abgespeicherten Störwertaufzeichnungen, die aus Störwertbibliotheken oder dergleichen entnommen werden und somit nicht neu erzeugt werden müssen. Das erfindungsgemäße Verfahren ermöglicht somit auf sehr einfache Weise die Bereitstellung von digitalen Abtastwerten zur systematischen und automatisierten Schutzprüfung beispielsweise auf der Basis des Standards IEC 61850-9-2.

Ein weiterer wesentlicher Vorteil des erfindungsgemäßen Verfahrens besteht darin, dass sich mit diesem auch qualitative Vergleiche zwischen digitalen Wandlern, die digitale Wandlerdaten ausgeben, und analogen Wandlern, die analoge Wandlersignale ausgeben, anstellen lassen, indem die Reaktion des zu testenden Schutzgerätes auf die eingespeisten netzwerkkompatiblen Datenpakete in Abhängigkeit davon ausgewertet wird, aus welcher Quelle die Datenpakete ursprünglich stammen.

Als Erfindung wird außerdem ein Feldgerät, insbesondere Schutzgerät, für eine zu überwachende elektrotechnische Anlage angesehen mit einer Vielzahl von analogen Eingängen zum Einspeisen eines analogen Messsignals, das sich auf die zu überwachende elektrotechnische Anlage bezieht, einer externen Kommunikationsschnittstelle zum Einspeisen digitaler Messsignale und mit einer mit den analogen Eingängen jeweils über eine A/D-Wandlereinheit und jeweilige digitale Signaleingänge und der externen Kommunikationsschnittstelle in Verbindung stehenden digital arbeitenden Auswerteinrichtung, die im Falle eines Anliegens des eingangsseitigen analogen Messsignals dieses auswertet und ein Fehlersignal erzeugt, falls das Messsignal auf einen Fehler in der zu überwachenden elektrotechnischen Anlage hindeutet.

Der Erfindung liegt bezüglich eines solchen Feldgerätes die Aufgabe zugrunde, eine einfache aber dennoch zuverlässige Testmöglichkeit für das Feldgerät bereitzustellen.

Diese Aufgabe wird erfindungsgemäß dadurch gelöst, dass das Feldgerät eine mit der Auswerteinrichtung einerseits und mit der externen Kommunikationsschnittstelle andererseits in Verbindung stehende geräteinterne Prüfeinrichtung aufweist, die geeignet ist, ein digitales Testsignal selbst zu erzeugen und nach einem Starten eines Testmodus das digitale Testsignal als Messsignal in die Auswerteinrichtung zum Testen des Feldgerätes einzuspeisen, wobei die geräteinterne Prüfeinrichtung geeignet ist, eine externe Störwertaufzeichnung zu laden und mit dieser das digitale Testsignal zu bilden oder die geladene Störwertaufzeichnung unmittelbar als digitales Testsignal weiterzuverwenden, indem die geräteinterne Prüfeinrichtung derart ausgestaltet ist, dass sie mit den Daten der externen Störwertaufzeichnung digitale Abtastwerte bildet, die während der Störwertaufzeichnung aufgenommenen Wandlerdaten zumindest eines Wandlers entsprechen, und diese zum Test des Feldgerätes heranzieht.

Zwecks Protokollierung der Tests ist die Prüfeinrichtung derart ausgestaltet, dass sie beim Durchführen des Testmodus das an die Auswerteinrichtung angelegte Testsignal sowie die entsprechende Reaktion des Feldgerätes darauf in Form eines Störschriebs abspeichert.

Als besonders vorteilhaft wird es angesehen, wenn das Feldgerät einen mit der geräteinternen Prüfeinrichtung in Verbindung stehenden Triggereingang aufweist, wobei die Prüfeinrichtung derart ausgestaltet ist, dass sie bei Anliegen eines Triggersignals an dem Triggereingang den Testmodus zum Testen des Feldgeräts startet.

Im Hinblick auf die Verwendung abgespeicherter bzw. konservierter Störwertaufzeichnungen, die beispielsweise in einer Datenbank aufbewahrt werden, wird es als vorteilhaft angesehen, wenn die geräteinterne Prüfeinrichtung geeignet ist, eine externe Störwertaufzeichnung zu laden und mit dieser das digitale Testsignal zu bilden oder die geladene Störwertaufzeichnung unmittelbar als digitales Testsignal weiterzuverwenden.

Beispielsweise ist die Prüfeinrichtung derart ausgestaltet, dass sie mit den Daten der externen Störwertaufzeichnung digitale Abtastwerte bildet, die während der Störwertaufzeichnung aufgenommenen Wandlerdaten zumindest eines Wandlers entsprechen, und diese zum Test des Feldgerätes heranzieht.

Vorzugsweise ist die Prüfeinrichtung außerdem geeignet, eine Störwertaufzeichnung eines analogen Wandlers mit analogen Wandlerdaten zu verarbeiten und mit diesen das digitale Testsignal zu bilden. Bevorzugt ist die Prüfeinrichtung auch geeignet, eine externe im Comtrade-Format vorliegende Störwertaufzeichnung weiterzuverarbeiten.

Als vorteilhaft wird es angesehen, wenn das Feldgerät einen Testmodus in netzwerkompatibler Form ausführen kann; vorzugsweise ist die Prüfeinrichtung hierzu derart ausgestaltet, dass sie das digitale Testsignal in digitale netzwerkkompatible Datenpakete einbettet und die netzwerkkompatiblen Datenpakete über einen geräteinternes Netzwerk zu einer geräteinternen netzwerkkompatiblen Schnittstelle der Auswerteinrichtung überträgt.

Als netzwerkkompatible Datenpakete werden vorzugsweise Ethernet-kompatible Datenpakete gebildet und über ein Ethernet-kompatibles Netzwerk übertragen. Beispielsweise werden die Ethernet-kompatiblen Datenpakete gemäß IEC61850-9-2-Standard gebildet.

Das geräteinterne Netzwerk kann beispielsweise durch ein Ethernet-kompatibles Netzwerk oder durch einen Datenbus nach dem SPI- oder CAN-Standard gebildet sein. Auch andere Netzwerkarten oder Datenbusarten können jedoch je nach Einsatzfall geeignet sein.

Im Hinblick auf eine zeitlich aufeinander abgestimmte Triggerung mehrerer Feldgeräte wird es als vorteilhaft angesehen, wenn die geräteinterne Prüfeinrichtung der Feldgeräte ein am Triggereingang anliegendes Uhrzeitsignal als Triggersignal weiterverarbeiten kann, indem sie zu einem Zeitpunkt, der durch das Uhrzeitsignal definiert ist, den jeweiligen Testmodus startet. Uhrzeitsignale erlauben es somit beispielsweise, die einzelnen Feldgeräte nicht gleichzeitig, sondern gezielt nacheinander bzw. kaskadiert zu starten.

Vorzugsweise weist das Feldgerät eine Kommunikationsschnittstelle, insbesondere einen Netzwerkanschluss, auf, wobei der Triggereingang bevorzugt durch diese Kommunikationsschnittstelle gebildet ist.

Falls die Auswerteinrichtung mehrere digitale Signalseingänge aufweist, wird es als vorteilhaft angesehen, wenn in die Prüfeinrichtung eine Konfigurationsdatei ladbar ist, die festlegt, an welchem digitalen Signaleingang der Auswerteinrichtung das digitale Testsignal von der Prüfeinrichtung angelegt werden soll. Vorzugsweise ist die Prüfeinrichtung derart ausgestaltet, dass sie mehrere digitale Testsignale gleichzeitig an die Auswerteinrichtung anlegen kann, wobei durch die Konfigurationsdatei festlegbar ist, wie die Zuordnung der Testsignale zu den Signaleingängen der Auswerteinrichtung erfolgen soll.

Im Hinblick auf möglichst zuverlässige Testergebnisse wird es als vorteilhaft angesehen, wenn die Prüfeinrichtung derart ausgestaltet ist, dass sie zum Testen des Feldgerätes ein digitales Testsignal wiederholt, insbesondere periodisch wiederholt, in die Auswerteinrichtung einspeist. Im Falle eines wiederholten Einspeisens des digitalen Testsignals können beispielsweise unterschiedliche Skalierfaktoren verwendet werden.

Vorzugsweise weist das Feldgerät einen abschaltbar ausgeführten Fehlersignalausgang zur externen Abgabe des Fehlersignals auf, wobei die Prüfeinrichtung derart ausgestaltet ist, dass sie im Falle des Testmodus den Fehlersignalausgang abschaltet oder deaktiviert. Durch ein Abschalten oder Deaktivieren des Fehlersignalausgangs lässt sich Verhindern, dass während eines Test ungewollt eine an das Feldgerät angeschlossene elektrotechnische Anlage bzw. Anlagenteile davon beeinflusst werden.

Bildet eine externe Kommunikationsschnittstelle, z. B. ein externer Netzwerkanschluss, den Fehlersignalausgang des Feldgeräts, so kann die Auswerteinrichtung - im Falle des Testmodus - am Fehlersignalausgang beispielsweise ein kodiertes Fehlersignal erzeugen, das auf die Durchführung eines Tests hinweist.

Die Erfindung bezieht sich außerdem auf ein Verfahren zum Testen einer Feldgeräteanordnung mit mindestens zwei Feldgeräten.

Der Erfindung liegt diesbezüglich die Aufgabe zugrunde, ein Testverfahren anzugeben, das es ermöglicht, auch komplexe Fehlersituationen in elektrotechnischen Anlagen zu Testzwecken nachbilden zu können.

Diese Aufgabe wird erfindungsgemäß dadurch gelöst, dass die Feldgeräte der Feldgeräteanordnung synchronisiert getestet werden.

Ein wesentlicher Vorteil des erfindungsgemäßen Verfahrens ist darin zu sehen, dass sich mit diesem auch sehr komplexe Fehlersituationen, wie sie in komplexen elektrotechnischen Anlagen auftreten können, als "Testmuster" zum Testen der Feldgeräte nachbilden bzw. simulieren lassen. Beispielsweise werden unterschiedliche zeitliche Abläufe innerhalb der angeschlossen Feldgeräte individuell gesteuert bzw. ausgelöst.

Vorzugsweise wird in mindestens eines der Feldgeräte ein Ausgangssignal (z. B. Fehlersignal, Triggersignal, Testergebnisse, Zwischenergebnisse während des Tests, sonstiges Auswertsignale) eines anderen Feldgerätes eingespeist, um Interkorrelationen zwischen Feldgeräten nachzubilden und zu testen. Beispielsweise kann zum Testen einer Differentialschutzanordnung ein solches Einspeisen von Ausgangssignalen anderer Feldgeräte sinnvoll sein.

Beispielsweise können die Feldgeräte das Ausgangssignal anderer Feldgeräte als digitales Testsignal weiterverwenden oder mit diesem ihr digitales Testsignal bilden. Auch ist es möglich, dass die Feldgeräte das Ausgangssignal anderer Feldgeräte als Triggersignal weiterverwenden oder mit diesem ihr eigenes Triggersignal bilden.

Die Erfindung wird nachfolgend anhand von Ausführungsbeispielen näher erläutert; dabei zeigen beispielhaft
- Figur 1: ein Ausführungsbeispiel einer Anordnung mit einem Schutzgerät, einer Prüfeinrichtung und einer separaten Bedieneinrichtung, anhand der Anordnung wird beispielhaft auch ein Verfahren zum Testen des Schutzgerätes erläutert;
- Figuren 2 und 3: beispielhaft Störwertaufzeichungen, mit denen das Schutzgerät gemäß der Figur 1 getestet werden soll;
- Figur 4: ein Ausführungsbeispiel eines erfindungsgemäßen Feldgerätes; und
- Figur 5: eine Anordnung mit mehreren Feldgeräten gemäß der Figur 4, anhand derer ein Ausführungsbeispiel eines erfindungsgemäßen Testverfahren beispielhaft erläutert wird.

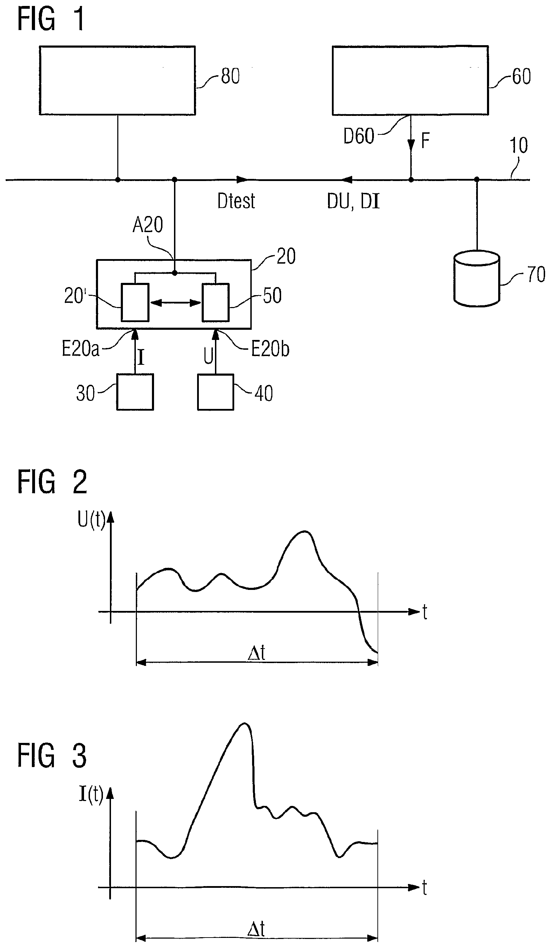

In der Figur 1 erkennt man ein Ethernet-Netzwerk bzw. ein Ethernet-Datenbus 10, der zum IEC61850-9-2-Standard, zum Real-Time-Ethernet-Standard, zum IEC 61850-Standard und/oder zum IEEE 1588-Standard kompatibel ist und nach diesen Standards betrieben werden kann.

An das Ethernet-Netzwerk 10 ist eine Merging Unit 20 mit ihrem Netzwerkanschluss A20 angeschlossen. Mit der Merging Unit 20 stehen analoge Spannungs- und Stromwandler in Verbindung, die an ein in der Figur 1 nicht weiter gezeigtes Energieübertragungssystem angeschlossen sind und analoge Strom- und Spannungsmesswerte U und I des Energieübertragungssystems erfassen sowie diese an die Merging Unit 20 übertragen. Die analogen Spannungs- und Stromwandler sind in der Figur 1 der Übersicht halber nur schematisch gezeigt und mit den Bezugszeichen 30 und 40 gekennzeichnet.

Die Spannungs- und Stromwandler 30 und 40 sind an die Merging Unit 20 beispielsweise über analoge 1/5A- oder 100V- Schnittstellen E20a und E20b angeschlossen.

Wie sich der Figur 1 außerdem entnehmen lässt, ist in der Merging Unit 20 eine Prüfeinrichtung 50 integriert, die mit einer Steuereinrichtung (z. B. Mikroprozessoreinrichtung) 20' der Merging Unit 20 verbunden bzw. in dieser integriert ist; die Funktionsweise der Prüfeinrichtung 50 wird weiter unten erläutert.

Mit dem Ethernet-Netzwerk 10 steht außerdem ein Schutzgerät 60, eine Datenbank 70 sowie eine Bedieneinrichtung 80 zum Bedienen, Steuern und Konfigurieren der Prüfeinrichtung 50 der Merging Unit 20 in Verbindung.

Die Anordnung gemäß der Figur 1 wird wie folgt betrieben:
Bevor mit dem Schutzgerät 60 das Energieübertragungssystem überwacht wird, wird mit der Prüfeinrichtung 50 die korrekte Funktionsweise des Schutzgeräts 60 überprüft. Hierzu werden im Comtrade-Format abgespeicherte Störwertaufzeichnungen aus der Datenbank 70 mit der Bedieneinrichtung 80 ausgelesen und zu der Prüfeinrichtung 50 übertragen.

In den Figuren 2 und 3 sind beispielhaft und nur schematisch Störwertaufzeichnungen in Form analoger Spannungs- und Stromverläufe U(t) und I(t) innerhalb eines Störwertaufzeichnungsintervalls Δt dargestellt. Eine Störwertaufzeichnung U(t) und I(t) umfasst somit eine Vielzahl an Einzel-Messwerten zu unterschiedlichen Zeitpunkten t innerhalb des jeweiligen Störwertaufzeichnungsintervalls Δt.

Die Prüfeinrichtung 50 empfängt die Störwertaufzeichnungen als Datenpakete DU und DI und wandelt diese in digitale Abtastwerte um, die den von den Störwertaufzeichnungs-Wandlern während der jeweiligen Störwertaufzeichnung aufgenommenen Wandlersignalen entsprechen.

Anschließend bettet die Prüfeinrichtung 50 die in dieser Weise aus den Störwertaufzeichnungen gebildeten Abtastwerte in digitale netzwerkkompatible Test-Datenpakete Dtest nach dem IEC61850-9-2-Standard ein und überträgt diese über ihren Netzwerkanschluss A20 zu einer netzwerkkompatiblen Schnittstelle D60 des Schutzgeräts 60.

Die Übertragung der Test-Datenpakete Dtest erfolgt dabei vorzugsweise derart, dass diese für das Schutzgerät 60 nicht von anderen Datenpaketen der Merging Unit 20 zu unterscheiden sind, die während des späteren "Normalbetriebs" der Merging Unit 20 unter Verwendung der analogen Strom- und Spannungsmesswerte U und I der analogen Spannungs- und Stromwandler 30 und 40 gebildet werden.

Mit der Bedieneinrichtung 80 werden bevorzugt Störwertaufzeichnungen zu der Prüfeinrichtung übertragen, die auf Fehler hindeuten, die das Schutzgerät 60 erkennen soll. Die Bedieneinrichtung 80 überwacht dabei, ob das Schutzgerät 60 die jeweiligen Fehler erkennt und entsprechende Fehlersignale F erzeugt. Ist dies der Fall, so arbeitet das Schutzgerät 60 korrekt und kann zur Überwachung des Energieübertragungssystems sowie zur Auswertung der analogen Strom- und Spannungsmesswerte U und I der Spannungs- und Stromwandler 30 und 40 verwendet werden; arbeitet das Schutzgerät 60 hingegen nicht korrekt, so sind geeignete Wartungs- oder Austauscharbeiten vorzunehmen.

Darüber hinaus ist es möglich, die Qualität des Schutzgerätes 60 quantitativ zu erfassen, indem die Reaktions- bzw. Auslösezeiten des Schutzgerätes 60 in Abhängigkeit von den eingespeisten Strom- und/oder Spannungswerten der Störwertaufzeichnungen gemessen und ausgewertet werden. Beispielsweise können zur Qualitätsbeurteilung die Auslösezeiten in Form von Auslösekennlinien in Abhängigkeit von den eingespeisten Spannungs- und/oder Stromwerten erfasst werden.

Im Hinblick auf einen möglichst umfassenden Test des Schutzgerätes 60 kann im Übrigen eine Vielzahl an Störwertaufzeichnungen in Form von repetierend übertragenen Testsequenzen in das Schutzgerät 60 eingespeist und dessen Reaktion wie beschrieben erfasst werden.

Bei dem Ausführungsbeispiel gemäß der Figur 1 ist die Prüfeinrichtung 50 beispielhaft in der Merging Unit 20 untergebracht. Erfindungsgemäß ist die Prüfeinrichtung 50 in dem Schutzgerät 60 integriert.

Entsprechendes gilt für die Bedieneinrichtung 80: Bei dem Ausführungsbeispiel gemäß der Figur 1 ist die Bedieneinrichtung 80, die beispielsweise durch eine entsprechend programmierte Datenverarbeitungsanlage wie einen Personal Computer oder dergleichen gebildet ist, als selbständiges Gerät direkt an das Ethernet-Netzwerk 10 angeschlossen. Alternativ kann die Bedieneinrichtung 80 auch in der Merging Unit 20 oder in dem Schutzgerät 60 integriert sein.

Im Übrigen müssen die Bedieneinrichtung 80 sowie die Datenbank 70 nicht unmittelbar an das Ethernet-Netzwerk 10 angeschlossen sein; stattdessen können diese Komponenten auch über das Internet mit dem Ethernet-Netzwerk 10 sowie mit den daran angeschlossenen Geräten in Verbindung stehen. Mit anderen Worten ist es also denkbar, Testsequenzen zum Testen des Schutzgerätes 60 aus mit dem Internet verbundenen Datenbanken herunterzuladen und diese zum Testen zu verwenden.

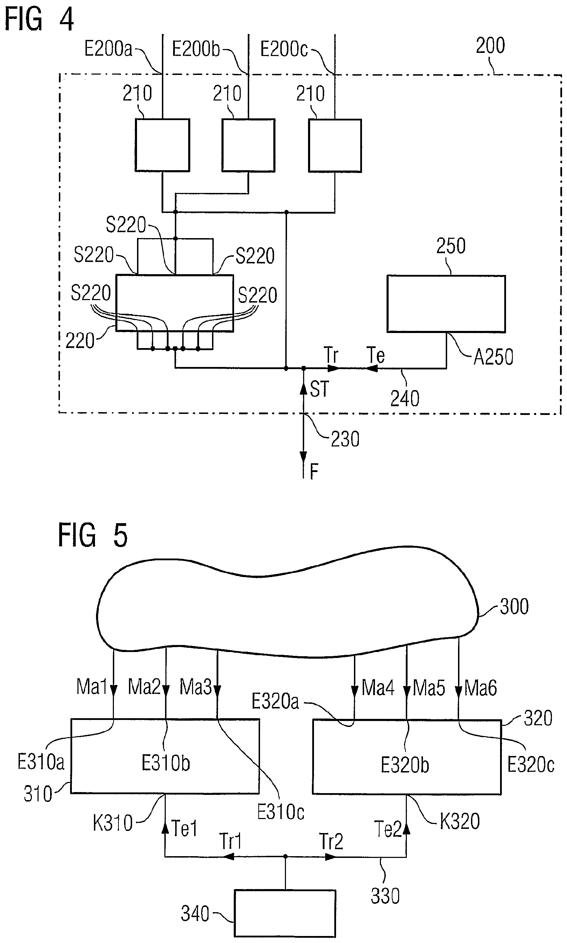

In der Figur 4 ist ein Ausführungsbeispiel für ein erfindungsgemäßes Feldgerät dargestellt. Bei dem Feldgerät handelt es sich um ein Schutzgerät, das in der Figur 4 mit dem Bezugszeichen 200 gekennzeichnet ist.

Das Schutzgerät 200 weist eine Vielzahl an analogen Eingängen zum Einspeisen analoger Messsignale auf; von diesen Eingängen sind in der Figur 4 beispielhaft drei dargestellt und mit den Bezugszeichen E200a, E200b und E200c gekennzeichnet. Jeder dieser analogen Eingänge E200a, E200b und E200c ist jeweils über eine A/D-Wandlereinheit 210 an digitale Signaleingänge S220 einer digital arbeitenden bzw. digitale Eingangssignale verarbeitenden Auswerteinrichtung 220 angeschlossen.

Die Auswerteinrichtung 220 wertet bei Anliegen der analogen Messsignale an den analogen Eingängen E200a, E200b und E200c diese nach erfolgter Analog-Digital-Umsetzung aus und erzeugt ein Fehlersignal F, wenn die anliegenden digitalen Messsignale auf einen Fehler in einer an die analogen Eingänge E200a, E200b und E200c angeschlossenen elektrotechnischen Anlage, die in der Figur 4 der Übersichtlichkeit halber nicht dargestellt ist, hindeutet.

Zur Ausgabe des Fehlersignals F ist die Auswerteinrichtung 220 mit einer externen Kommunikationsschnittstelle 230 verbunden, die u. a. einen Fehlersignalausgang des Schutzgerätes 200 bildet.

Die externe Kommunikationsschnittstelle 230 bildet darüber hinaus einen Eingang zum Einspeisen digitaler Messsignale in die Auswerteinrichtung 220. Die externe Kommunikationsschnittstelle 230 ist hierzu mit den digitalen Signaleingängen S220 der Auswerteinrichtung 220 verbunden, und zwar über eine geräteinterne Verbindungseinrichtung 240. Bei der geräteinternen Verbindungseinrichtung 240 kann es sich beispielsweise um einen internen Datenbus (z. B. SPI- oder CAN-Standard) oder ein internes Netzwerk (z. B. Ethernet) oder dergleichen handeln.

Über die externe Kommunikationsschnittstelle 230 ist es somit möglich, digitale Messsignale in die Auswerteinrichtung 220 einzuspeisen, die sich ebenfalls auf eine an das Schutzgerät 200 angeschlossene elektrotechnische Anlage beziehen können, beispielsweise auf dieselbe elektrotechnische Anlage, die an die analogen Eingänge E200a, E200b und E200c angeschlossen ist oder angeschlossen wird. Das Schutzgerät 200 bietet also die Möglichkeit, sowohl analoge als auch digitale Messsignale auszuwerten.

Um einen einfachen Gerätetest des Schutzgerätes 200 zu ermöglichen, weist dieses zusätzlich eine geräteinterne Prüfeinrichtung 250 auf, die über die geräteinterne Verbindungseinrichtung 240 sowohl mit der Auswerteinrichtung 220 als auch mit der externen Kommunikationsschnittstelle 230 in Verbindung steht und einen Testmodus des Schutzgerätes ermöglicht.

Die geräteinterne Prüfeinrichtung 250 ist während des Testmodus in der Lage, digitale Testsignale Te über die geräteinterne Verbindungseinrichtung 240 in die Auswerteinrichtung 220 einzuspeisen; hierzu bedient sie sich der digitalen Signaleingänge S220 der Auswerteinrichtung 220. Im Rahmen des Testmodus wertet die Auswerteinrichtung 220 die eingangsseitig anliegenden Testsignale Te aus - und zwar genauso wie die im Normalbetrieb anliegenden digitalen Messsignale oder analog/digital umgewandelten Messsignale der angeschlossenen elektrotechnischen Anlage - und erzeugt an der externen Kommunikationsschnittstelle 230 ein Fehlersignal F, wenn die digitalen Testsignale auf einen Fehler hinweisen.

Um von außen auf das Schutzgerät 200 derart einwirken zu können, dass der Testmodus zu ganz bestimmten Zeiten ausgelöst wird, weist das Schutzgerät 200 einen Triggereingang auf, der ebenfalls durch die externe Kommunikationsschnittstelle 230 gebildet ist. Es ist somit möglich, von außen ein Triggersignal Tr in das Schutzgerät 200 und somit in die Prüfeinrichtung 250 einzuspeisen und den Testmodus des Schutzgerätes auszulösen. Bei Vorliegen des Triggersignals Tr an einem Anschluss A250 der Prüfeinrichtung 250 erzeugt dieses die digitalen Testsignale Te, mit denen die Auswerteinrichtung 220 getestet wird.

Die digitalen Testsignale Te können vorab von außen vorgegeben bzw. eingestellt werden. So ist es beispielsweise möglich, von außen über die externe Kommunikationsschnittstelle 230 konkrete digitale Testsignale Te in die Prüfeinrichtung 250 zu übertragen und dort abzuspeichern, damit die Prüfeinrichtung 250 die digitalen Testsignale Te zu einem späteren Zeitpunkt als digitale Messsignale in die Auswerteinrichtung 220 einspeisen kann. Die digitalen Testsignale Te können beispielsweise durch Simulation oder durch Auswerten von Störwertaufzeichnungen gebildet worden sein, die an realen elektrotechnischen Anlagen aufgezeichnet worden sind.

Alternativ ist es möglich, über die Kommunikationsschnittstelle 230 direkt digitale oder analoge Störwertaufzeichnungen in die Prüfeinrichtung 250 zu übertragen, damit die Prüfeinrichtung 250 mit diesen die digitalen Testsignale Te selbst erzeugen kann.

Auch ist es möglich, über die externe Kommunikationsschnittstelle 230 in die Prüfeinrichtung 250 Steuersignale ST zu übertragen, die bestimmte Testmuster, die in der Prüfeinrichtung 250 vorinstalliert sind, auszulösen. In einem solchen Fall legt also das Steuersignal ST fest, welche Testsignale Te zur Auswerteinrichtung 220 übertragen werden sollen. Im Rahmen einer solchen Steuersignalübertragung können beispielsweise auch Skalierfaktoren oder dergleichen mitübertragen werden, die angeben, in welcher Weise die in der Prüfeinrichtung 250 vorinstallierten Testmuster umskaliert werden sollen, um zu den gewünschten digitalen Testsignalen Te zu gelangen.

Falls über die Kommunikationsschnittstelle 230 Störwertaufzeichnungen in die Prüfeinrichtung 250 übertragen werden, so erfolgt dies vorzugsweise im sogenannten Comtrade-Format (Common Format for Transient Data - IEEE C37.111- 1999).

Um festzulegen, von welchen internen digitalen Signaleingängen S220 der Auswerteinrichtung 220 die digitalen Testsignale Te weiterverarbeitet werden sollen, lässt sich über die Kommunikationsschnittstelle 230 in die Prüfeinrichtung 250 darüber hinaus eine Konfigurationsdatei übertragen, die festlegt, wie die Zuordnung der digitalen Testsignale Te zu den einzelnen Signaleingängen der Auswerteinrichtung 220 erfolgen soll. In dieser Weise ist es beispielsweise möglich, jeden der digitalen Signaleingänge S220 der Auswerteinrichtung 220 separat anzusprechen und zu testen, um sicherzustellen, dass jeder einzelne der digitalen Signaleingänge S220 korrekt arbeitet.

Um zu vermeiden, dass ein mit dem Schutzgerät 200 während eines Testmodus bzw. Testzyklus erzeugtes Fehlersignal F zu einem Auslösen einer Sicherheitsreaktion, beispielsweise einem Abschalten einer an das Schutzgerät 200 angeschlossenen elektrotechnischen Anlage, führt, ist das Schutzgerät 200 derart ausgestaltet, dass während eines Testmodus bei der Ausgabe des Fehlersignals F über die externe Kommunikationsschnittstelle 230 zusätzlich angegeben wird, dass es sich um ein im Rahmen eines Testmodus generiertes Fehlersignal handelt. Alternativ kann während des Testmodus der durch die Kommunikationsschnittstelle 230 gebildete Fehlersignalausgang auch hardwaremäßig abgeschaltet werden, um eine unerwünschte Ausgabe des Fehlersignals F zu unterdrücken.

Die Auswerteinrichtung 220 ist vorzugsweise derart ausgestaltet, dass sie die eingangsseitig anliegenden analogen oder digitalen Messsignale sowie die auf der Basis dieser Messsignale erzeugten Fehlersignale in Form von Störschrieben (z. B. im Comtrade-Format) abspeichert, um nachträglich ein Auslesen und Weiterverarbeiten dieser Daten zu ermöglichen. Hierzu kann beispielsweise die Kommunikationsschnittstelle 230 verwendet werden. Die Auswerteinrichtung 220 erzeugt derartige Störschriebe vorzugsweise sowohl für den Normalbetriebsmodus, bei dem eine reale elektrotechnische Anlage messtechnisch überwacht wird und "reale" Fehlersignale erzeugt werden, als auch für den Testmodus, bei dem die digitalen Testsignale Te der Prüfeinrichtung 250 zu Testzwecken verarbeitet und Test-Fehlersignale erzeugt werden.

Bei dem Ausführungsbeispiel gemäß der Figur 4 wurde beispielhaft davon ausgegangen, dass die Prüfeinrichtung 250 und die Auswerteinrichtung 220 separate Teilkomponenten sind; alternativ können die Prüfeinrichtung 250 und die Auswerteinrichtung 220 auch durch eine einzige Steuereinrichtung (z. B. eine Mikroprozessoranordnung) gebildet sein, in der die Prüfeinrichtung 250 und die Auswerteinrichtung 220 softwaremäßig als Softwaremodule implementiert sind. In diesem Falle lassen sich die Prüfeinrichtung 250 und die Auswerteinrichtung 220 bilden, indem ein entsprechendes Computerprogrammprodukt in der Mikroprozessoranordnung installiert wird.

In der Figur 5 ist eine Feldgeräteanordnung mit zwei Feldgeräten dargestellt, mit denen sich auch komplexe Netzstörungen nachbilden und damit zu Testzwecken heranziehen lassen.

In der Figur 5 ist eine elektrotechnische Anlage 300 zu erkennen, an die zwei Schutzgeräte 310 und 320 angeschlossen sind. Die beiden Schutzgeräte 310 und 320 können beispielsweise von ihrem Aufbau her dem Schutzgerät 200 gemäß der Figur 4 entsprechen.

Die beiden Schutzgeräte 310 und 320 sind jeweils mit ihren analogen Eingängen E310a, E310b und E310c bzw. E320a, E320b und E320c - die den Eingängen E200a, E200b und E200c gemäß der Figur 4 entsprechen - derart an die elektrotechnische Anlage 300 angeschlossen, dass analoge Messsignale Mal bis Ma6 in die beiden Schutzgeräte 310 und 320 eingespeist werden. Diese werden von in den Schutzgeräten enthaltenen A/D-Wandlereinheiten in digitale Messsignale umgewandelt und anschließend von einer Auswerteinrichtung des jeweiligen Schutzgeräts ausgewertet. Diesbezüglich sei auf die obigen Ausführungen im Zusammenhang mit der Figur 4 verwiesen.

In der Figur 5 erkennt man darüber hinaus ein geräteexternes Netzwerk 330, das Kommunikationsschnittstellen K310 und K320 der beiden Schutzgeräte 310 und 320, die jeweils der Kommunikationsschnittstelle 230 gemäß der Figur 4 entsprechen, miteinander verbindet.

Mit dem geräteexternen Netzwerk 330 steht darüber hinaus eine externe Bedieneinrichtung 340 in Verbindung, mit der sich die beiden Schutzgeräte 310 und 320 von außen steuern lassen. So erlaubt es die Bedieneinrichtung 340, ein Triggersignal Tr1 in das Schutzgerät 310 und ein weiteres Triggersignal Tr2 in das Schutzgerät 320 einzuspeisen. Die beiden Triggersignale Tr1 und Tr2 können gleichzeitig in die beiden Schutzgeräte eingespeist werden, wenn diese gleichzeitig in einen Testmodus geschaltet werden sollen. Alternativ ist es möglich, die beiden Triggersignale Tr1 und Tr2 zeitlich versetzt zu erzeugen, um die beiden Schutzgeräte zu unterschiedlichen Zeitpunkten, aber trotzdem synchronisiert zueinander, in ihren Testmodus zu versetzen.

Darüber hinaus erlaubt es die Bedieneinrichtung 340, die für den Testmodus zu verwendenden digitalen Testsignale Tel und Te2 über das geräteexterne Netzwerk 330 zu den jeweiligen Schutzgeräten 310 und 320 zu übertragen. Anstelle der digitalen Testsignale Tel und Te2, die für den Testmodus verwendet werden sollen, können auch Dateien beispielsweise in Form von Störwertaufzeichnungen im Comtrade-Format zu den Schutzgeräten übermittelt werden, mit denen die Schutzgeräte die endgültigen Testsignale Tel bzw. Te2 selbst bilden. Das Erzeugen der Triggersignale Tr1 und Tr2 erfolgt in einem solchen Falle vorzugsweise erst dann, wenn die zu verwendenden Testsignale Tel und Te2 für den Testmodus bereits vollständig in den Schutzgeräten 310 und 320 über das Netzwerk 330 implementiert bzw. darin vorbereitet worden sind.

Sobald die Triggersignale Tr1 und Tr2 in ihrem jeweils zugeordneten Schutzgerät 310 bzw. 320 den Testmodus ausgelöst haben, so erzeugen die in den beiden Schutzgeräten 310 und 320 enthaltenen geräteinternen Prüfeinrichtungen jeweils die über die Bedieneinrichtung 340 vorab definierten digitalen Testsignale Te1 bzw. Te2 und speisen diese in die jeweils zugeordnete Auswerteinrichtung ein. Bezüglich des Zusammenwirkens zwischen Prüfeinrichtung und Auswerteinrichtung in jeder der beiden Schutzgeräte 310 und 320 sei auf die obigen Ausführungen im Zusammenhang mit dem Schutzgerät 200 gemäß Figur 4 verwiesen.

Neben einer ausschließlich externen Triggerung der beiden Schutzgeräte 310 und 320 mittels der Bedieneinrichtung 340 ist es darüber hinaus möglich, die beiden Schutzgeräte derart zu betreiben, dass sie miteinander kommunizieren. So ist es beispielsweise möglich, dass eines der beiden Schutzgeräte (beispielsweise das Schutzgerät 310) ein anderes Schutzgerät (beispielsweise das Schutzgerät 320) über das geräteexterne Netzwerk 320 triggert. Der Zeitpunkt für eine solche schutzgeräteseitige Triggerung kann beispielsweise davon abhängig sein, ob bzw. wann in dem triggernden Schutzgerät vorgegebene Triggerzustände (z. B. Feststellen eines Fehlers, Überschreiten vorgegebener Messwertgrenzen etc.) festgestellt werden.

Auch ist es möglich, dass eines der beiden Schutzgeräte (beispielsweise das Schutzgerät 310) Messsignale, selbst erzeugte oder von außen vorgegebene Auswertsignale, selbst erzeugte Zwischensignale oder dergleichen in das andere Schutzgerät (beispielsweise das Schutzgerät 320) über das geräteexterne Netzwerk 320 einspeist, so dass dieses die empfangenen Signale als Testsignale Te2 weiterverwenden oder mit diesen eigene Testsignale Te2 bilden kann. In diesem Falle würden die Schutzgeräte "zusammenarbeiten" und als Einheit getestet werden, wodurch sich auch sehr komplexe Fehlersituationen nachbilden und zu Testzwecken heranziehen lassen.

## Patentansprüche

1. Verfahren zum Testen eines Feldgerätes (200), wobei das Feldgerät (200)
- eine Vielzahl analoger Eingänge (E200a, E200b, E200c) zum Einspeisen eines analogen Messsignals (Ma1, Ma2, Ma3, Ma4, Ma5, Ma6) aufweist, das sich auf eine zu überwachende elektrotechnische Anlage bezieht,
- eine externe Kommunikationsschnittstelle (230) zum Einspeisen digitaler Messsignale aufweist, und
- eine mit den analogen Eingängen (E200a, E200b, E200c) jeweils über eine A/D-Wandlereinheit (210) und jeweilige digitale Signaleingänge (S220) und mit der externen Kommunikationsschnittstelle (23) in Verbindung stehende digital arbeitende Auswerteinrichtung (220) aufweist, die im Falle eines Anliegens des eingangsseitigen analogen Messsignals dieses auswertet und ein Fehlersignal (F) erzeugt, falls das Messsignal auf einen Fehler in der zu überwachenden elektrotechnischen Anlage hindeutet, wobei
- eine mit der Auswerteinrichtung (220) einerseits und mit der externen Kommunikationsschnittstelle (230) andererseits in Verbindung stehende geräteinterne Prüfeinrichtung (250) des Feldgerätes (200) ein digitales Testsignal (Te) selbst erzeugt und
- die geräteinterne Prüfeinrichtung (250) nach einem Starten eines Testmodus das digitale Testsignal als Messsignal in die Auswerteinrichtung (220) zum Testen des Feldgerätes (200) einspeist, wobei
- über die externe Kommunikationsschnittstelle (230) externe Störwertaufzeichnungen in die Prüfeinrichtung (250) übertragen werden und
- die geräteinterne Prüfeinrichtung (250) mit den Störwertaufzeichnungen die digitalen Testsignale (Te) erzeugt, indem sie mit den Daten der externen Störwertaufzeichnung digitale Abtastwerte bildet, die während der Störwertaufzeichnung aufgenommenen Wandlerdaten zumindest eines Wandlers entsprechen, und diese zum Test des Feldgerätes heranzieht; und
- die geräteinterne Prüfeinrichtung (250) beim Durchführen des Testmodus das an die Auswerteeinrichtung (230) angelegte Testsignal sowie die entsprechende Reaktion des Feldgerätes darauf in Form eines Störschriebes abspeichert.

2. Feldgerät (200, 310, 320), insbesondere Schutzgerät, für eine zu überwachende elektrotechnische Anlage (300) mit
- einer Vielzahl von analogen Eingängen (E200a, E200b, E200c) zum Einspeisen eines analogen Messsignals (Ma1, Ma2, Ma3, Ma4, Ma5, Ma6), das sich auf die zu überwachende elektrotechnische Anlage bezieht,
- einer externen Kommunikationsschnittstelle (230) zum Einspeisen digitaler Messsignale und
- mit einer mit den analogen Eingängen jeweils über eine A/D-Wandlereinheit (210) und jeweilige digitale Signaleingänge (S220) und mit der externen Kommunikationsschnittstelle (230) in Verbindung stehenden digital arbeitenden Auswerteinrichtung (220), die im Falle eines Anliegens des eingangsseitigen analogen Messsignals dieses auswertet und ein Fehlersignal (F) erzeugt, falls das Messsignal auf einen Fehler in der zu überwachenden elektrotechnischen Anlage hindeutet, wobei
- das Feldgerät eine mit der Auswerteinrichtung (220) einerseits und mit der externen Kommunikationsschnittstelle (230) andererseits in Verbindung stehende geräteinterne Prüfeinrichtung (250) aufweist, die geeignet ist,
- ein digitales Testsignal (Te) selbst zu erzeugen und
- nach einem Starten eines Testmodus das digitale Testsignal als Messsignal in die Auswerteinrichtung (220) zum Testen des Feldgerätes einzuspeisen, wobei die geräteinterne Prüfeinrichtung (250) geeignet ist, eine externe Störwertaufzeichnung zu laden und mit dieser das digitale Testsignal zu bilden oder die geladene Störwertaufzeichnung unmittelbar als digitales Testsignal weiterzuverwenden, indem die geräteinterne Prüfeinrichtung (250) derart ausgestaltet ist, dass sie mit den Daten der externen Störwertaufzeichnung digitale Abtastwerte bildet, die während der Störwertaufzeichnung aufgenommenen Wandlerdaten zumindest eines Wandlers entsprechen, und diese zum Test des Feldgerätes heranzieht, wobei
- die geräteinterne Prüfeinrichtung (250) derart ausgestaltet ist, dass sie beim Durchführen des Testmodus das an die Auswerteinrichtung (230) angelegte Testsignal sowie die entsprechende Reaktion des Feldgerätes darauf in Form eines Störschriebs abspeichert.

3. Feldgerät nach Anspruch 2,
**dadurch gekennzeichnet, dass**
- das Feldgerät einen mit der geräteinternen Prüfeinrichtung (250) in Verbindung stehenden Triggereingang (230) aufweist,
- wobei die Prüfeinrichtung (250) derart ausgestaltet ist, dass sie bei Anliegen eines Triggersignals an dem Triggereingang den Testmodus zum Testen des Feldgeräts startet.

4. Feldgerät nach einem der voranstehenden Ansprüche 2 oder 3,
**dadurch gekennzeichnet, dass**
die geräteinterne Prüfeinrichtung (250) geeignet ist, eine Störwertaufzeichnung eines analogen Wandlers mit analogen Wandlerdaten zu verarbeiten und mit diesen das digitale Testsignal zu bilden.

5. Feldgerät nach einem der voranstehenden Ansprüche 2-4,
**dadurch gekennzeichnet, dass**
die geräteinterne Prüfeinrichtung (250) geeignet ist, eine externe im Comtrade-Format vorliegende Störwertaufzeichnung weiterzuverarbeiten.

6. Feldgerät nach einem der voranstehenden Ansprüche 2-5,
**dadurch gekennzeichnet, dass**
die geräteinterne Prüfeinrichtung (250) derart ausgestaltet ist, dass sie
- das digitale Testsignal in digitale netzwerkkompatible Datenpakete einbettet und
- die netzwerkkompatiblen Datenpakete über ein geräteinternes Netzwerk (240) zu einer geräteinternen netzwerkkompatiblen Schnittstelle der Auswerteinrichtung überträgt.

7. Feldgerät nach Anspruch 6,
**dadurch gekennzeichnet, dass**
das geräteinterne Netzwerk (240) durch ein Ethernet-kompatibles Netzwerk oder durch einen Datenbus nach dem SPI- oder CAN-Standard gebildet ist.

8. Feldgerät nach einem der voranstehenden Ansprüche 3-7,
**dadurch gekennzeichnet, dass**
die geräteinterne Prüfeinrichtung (250) derart ausgestaltet ist, dass sie ein am Triggereingang anliegendes Uhrzeitsignal als Triggersignal weiterverarbeitet, indem sie zu einem Zeitpunkt, der durch das Uhrzeitsignal definiert ist, den Testmodus startet.

9. Feldgerät nach einem der voranstehenden Ansprüche 3-8,
**dadurch gekennzeichnet, dass**
die externe Kommunikationsschnittstelle (230) ein Netzwerkanschluss ist und der Triggereingang durch die externe Kommunikationsschnittstelle (230) gebildet ist.

10. Feldgerät nach einem der voranstehenden Ansprüche 2-9,
**dadurch gekennzeichnet, dass**
- die Auswerteinrichtung (230) mehrere digitale Signaleingänge (S200) aufweist und
- dass in die geräteinterne Prüfeinrichtung (250) eine Konfigurationsdatei ladbar ist, die festlegt, an welchem digitalen Signaleingang (S200) der Auswerteinrichtung (230) das digitale Testsignal von der Prüfeinrichtung (250) angelegt werden soll.

11. Feldgerät nach Anspruch 10,
**dadurch gekennzeichnet, dass**
- die geräteinterne Prüfeinrichtung (250) derart ausgestaltet ist, dass sie mehrere digitale Testsignale gleichzeitig an die Auswerteinrichtung (230) anlegen kann,
- wobei durch die Konfigurationsdatei festlegbar ist, wie die Zuordnung der Testsignale zu den Signaleingängen (S200) der Auswerteinrichtung (230) erfolgen soll.

12. Feldgerät nach einem der voranstehenden Ansprüche 2-11,
**dadurch gekennzeichnet, dass**
die geräteinterne Prüfeinrichtung (250) derart ausgestaltet ist, dass sie zum Testen des Feldgerätes ein digitales Testsignal wiederholt, insbesondere periodisch wiederholt, in die Auswerteinrichtung (230) einspeist.

13. Feldgerät nach Anspruch 12,
**dadurch gekennzeichnet, dass**
die geräteinterne Prüfeinrichtung (250) derart ausgestaltet ist, dass sie im Falle eines wiederholten Einspeisens des digitalen Testsignals unterschiedliche Skalierfaktoren verwendet.

14. Feldgerät nach einem der voranstehenden Ansprüche 2-13,
**dadurch gekennzeichnet, dass**
- das Feldgerät einen abschaltbar ausgeführten Fehlersignalausgang zur externen Abgabe des Fehlersignals aufweist und
- dass die geräteinterne Prüfeinrichtung (250) derart ausgestaltet ist, dass sie im Falle des Testmodus den Fehlersignalausgang abschaltet oder deaktiviert.

15. Feldgerät nach einem der voranstehenden Ansprüche 2-14,
**dadurch gekennzeichnet, dass**
- die externe Kommunikationsschnittstelle (230) des Feldgeräts einen Fehlersignalausgang zur externen Abgabe des Fehlersignals bildet und
- dass die Auswerteinrichtung (250) derart ausgestaltet ist, dass sie im Falle des Testmodus an der externen Kommunikationsschnittstelle (230) ein kodiertes Fehlersignal erzeugt, das auf die Durchführung eines Tests hinweist.

16. Verfahren nach Anspruch 1, bei dem eine Feldgeräteanordnung mit mindestens zwei Feldgeräten (310, 320), die gemäß einem der voranstehenden Ansprüche 2 bis 15 ausgebildet sind, getestet wird,
**dadurch gekennzeichnet, dass**
die Feldgeräte der Feldgeräteanordnung synchronisiert getestet werden.

17. Verfahren nach Anspruch 16,
**dadurch gekennzeichnet, dass**
an jedes der Feldgeräte jeweils ein Triggersignal (Tr1, Tr2) derart angelegt wird, dass die Feldgeräte ihren jeweiligen Testmodus zeitlich korreliert zueinander ausführen.

18. Verfahren nach einem der Ansprüche 16 oder 17,
**dadurch gekennzeichnet, dass**
in mindestens eines der Feldgeräte ein Ausgangssignal eines anderen Feldgerätes eingespeist wird.

19. Verfahren nach Anspruch 18,
**dadurch gekennzeichnet, dass**
das mindestens eine Feldgerät das Ausgangssignal des anderen Feldgerätes als digitales Testsignal weiter verwendet oder mit diesem sein digitales Testsignal bildet.

20. Verfahren nach Anspruch 18 oder 19,
**dadurch gekennzeichnet, dass**
das mindestens eine Feldgerät das Ausgangssignal des anderen Feldgerätes als Triggersignal weiter verwendet oder mit diesem sein Triggersignal bildet.

## Claims

1. Method for testing a field device (200), wherein the field device (200)
- has a multiplicity of analogue inputs (E200a, E200b, E200c) for feeding in an analogue measurement signal (Ma1, Ma2, Ma3, Ma4, Ma5, Ma6) that relates to an electrotechnical installation to be monitored,
- has an external communication interface (230) for feeding in digital measurement signals, and
- has a digitally operating evaluation apparatus (220) connected to the analogue inputs (E200a, E200b, E200c) in each case via an A/D converter unit (210) and respective digital signal inputs (S220) and to the external communication interface (23), which evaluation apparatus, if the input-side analogue measurement signal is applied, evaluates it and generates a fault signal (F) if the measurement signal indicates a fault in the electrotechnical installation to be monitored, wherein
- a test apparatus (250), internal to the device and connected to the evaluation apparatus (220) on the one hand and to the external communication interface (230) on the other hand, of the field device (200) generates a digital test signal (Te) itself and
- the test apparatus (250) internal to the device, after a test mode is started, feeds the digital test signal as measurement signal into the evaluation apparatus (220) in order to test the field device (200), wherein
- external fault value records are transmitted into the test apparatus (250) via the external communication interface (230) and
- the test apparatus (250) internal to the device uses the fault value records to generate the digital test signals (Te) by using the data from the external fault value record to form digital sample values that correspond to converter data, recorded during the fault value recording, of at least one converter, and using these to test the field device; and
- the test apparatus (250) internal to the device, when performing the test mode, stores the test signal applied to the evaluation apparatus (230) and the corresponding response of the field device thereto in the form of a fault record.

2. Field device (200, 310, 320), in particular protective device, for an electrotechnical installation (300) to be monitored, having
- a multiplicity of analogue inputs (E200a, E200b, E200c) for feeding in an analogue measurement signal (Ma1, Ma2, Ma3, Ma4, Ma5, Ma6) that relates to the electrotechnical installation to be monitored,
- an external communication interface (230) for feeding in digital measurement signals, and
- having a digitally operating evaluation apparatus (220) connected to the analogue inputs in each case via an A/D converter unit (210) and respective digital signal inputs (S220) and to the external communication interface (230), which evaluation apparatus, if the input-side analogue measurement signal is applied, evaluates it and generates a fault signal (F) if the measurement signal indicates a fault in the electrotechnical installation to be monitored, wherein
- the field device has a test apparatus (250), internal to the device and connected to the evaluation apparatus (220) on the one hand and to the external communication interface (230) on the other hand, which test apparatus is suitable
- for generating a digital test signal (Te) itself and
- after a test mode is started, for feeding the digital test signal as measurement signal into the evaluation apparatus (220) in order to test the field device, wherein the test apparatus (250) internal to the device is suitable for loading an external fault value record and using this to form the digital test signal or for further using the loaded fault value record directly as digital test signal, in that the test apparatus (250) internal to the device is designed such that it uses the data from the external fault value record to form digital sample values that correspond to converter data, recorded during the fault value recording, of at least one converter, and uses these to test the field device, wherein
- the test apparatus (250) internal to the device is designed such that, when performing the test mode, it stores the test signal applied to the evaluation apparatus (230) and the corresponding response of the field device thereto in the form of a fault record.

3. Field device according to Claim 2,
**characterized in that**
- the field device has a trigger input (230) connected to the test apparatus (250) internal to the device,
- wherein the test apparatus (250) is designed such that, when a trigger signal is applied to the trigger input, it starts the test mode in order to test the field device.

4. Field device according to either of preceding Claims 2 and 3,
**characterized in that**
the test apparatus (250) internal to the device is suitable for processing a fault value record of an analogue converter containing analogue converter data and using this to form the digital test signal.

5. Field device according to one of preceding Claims 2-4,
**characterized in that**
the test apparatus (250) internal to the device is suitable for further processing an external fault value record present in the Comtrade format.

6. Field device according to one of preceding Claims 2-5,
**characterized in that**
the test apparatus (250) internal to the device is designed such that it
- embeds the digital test signal into digital network-compatible data packets and
- transmits the network-compatible data packets to a network-compatible interface of the evaluation apparatus internal to the device via a network (240) internal to the device.

7. Field device according to Claim 6,
**characterized in that**
the network (240) internal to the device is formed by an Ethernet-compatible network or by a data bus in accordance with the SPI or CAN standard.

8. Field device according to one of preceding Claims 3-7,
**characterized in that**
the test apparatus (250) internal to the device is designed such that it further processes a time signal applied to the trigger input as trigger signal by starting the test mode at a time that is defined by the time signal.

9. Field device according to one of preceding Claims 3-8,
**characterized in that**
the external communication interface (230) is a network connection and the trigger input is formed by the external communication interface (230).

10. Field device according to one of preceding Claims 2-9,
**characterized in that**
- the evaluation apparatus (230) has a plurality of digital signal inputs (S200) and
- **in that** a configuration file is able to be loaded into the test apparatus (250) internal to the device, which configuration file stipulates the digital signal input (S200) of the evaluation apparatus (230) to which the digital test signal should be applied by the test apparatus (250).

11. Field device according to Claim 10,
**characterized in that**
- the test apparatus (250) internal to the device is designed such that it is able to apply a plurality of digital test signals simultaneously to the evaluation apparatus (230),
- wherein the configuration file is able to stipulate how the test signals should be assigned to the signal inputs (S200) of the evaluation apparatus (230).

12. Field device according to one of preceding Claims 2-11,
**characterized in that**
the test apparatus (250) internal to the device is designed such that, in order to test the field device, it repeatedly, in particular periodically repeatedly, feeds a digital test signal into the evaluation apparatus (230).

13. Field device according to Claim 12,
**characterized in that**
the test apparatus (250) internal to the device is designed such that it uses different scaling factors in the event of repeated feeding-in of the digital test signal.

14. Field device according to one of preceding Claims 2-13,
**characterized in that**
- the field device has an error signal output, configured so as to be able to be switched off, for externally outputting the error signal and
- **in that** the test apparatus (250) internal to the device is designed such that it switches off or deactivates the error signal output in the event of the test mode.

15. Field device according to one of preceding Claims 2-14,
**characterized in that**
- the external communication interface (230) of the field device forms an error signal output for externally outputting the error signal and
- **in that** the evaluation apparatus (250) is designed such that, in the event of the test mode, it generates a coded error signal that indicates the performance of a test on the external communication interface (230).

16. Method according to Claim 1, wherein a field device arrangement having at least two field devices (310, 320) that are designed in accordance with one of preceding Claims 2 to 15 is tested,
**characterized in that**
the field devices of the field device arrangement are tested in a synchronized manner.

17. Method according to Claim 16,
**characterized in that**
a trigger signal (Tr1, Tr2) is applied in each case to each of the field devices such that the field devices execute their respective test mode in a manner temporally correlated with one another.

18. Method according to either of Claims 16 and 17,
**characterized in that**
an output signal of another field device is fed into at least one of the field devices.

19. Method according to Claim 18,
**characterized in that**
the at least one field device further uses the output signal of the other field device as digital test signal or uses it to form its digital test signal.

20. Method according to Claim 18 or 19,
**characterized in that**
the at least one field device further uses the output signal of the other field device as trigger signal or uses it to form its trigger signal.

## Revendications

1. Procédé de test d'un appareil (200) sur site, dans lequel l'appareil (200) sur site
- a une pluralité d'entrées (E200a, E200b, E200,c) analogiques pour l'injection d'un signal (Ma1, Ma2, Ma3, Ma4, Ma5, Ma6) analogique de mesure, qui se rapporte à une installation électrotechnique à contrôler,
- a une interface (230) extérieure de communication pour l'injection de signaux numériques de mesure et
- a un dispositif (220) d'exploitation, travaillant de manière numérique, qui est en liaison avec les entrées (E200a, E200b, E200,c) analogiques, respectivement, par une unité (210) de convertisseur A/N et avec, respectivement, des entrées (S220) numériques de signal et avec l'interface (23) extérieure de communication et qui, si un signal analogique de mesure du côté de l'entrée est appliqué, exploite celui-ci et produit un signal (F) de défaut, si le signal de mesure indique un défaut de l'installation électrotechnique à contrôler, dans lequel
- un dispositif (250) de contrôle de l'appareil (200) sur site, qui est interne à l'appareil et qui est en liaison avec le dispositif (220) d'exploitation d'une part et d'autre part avec l'interface (230) extérieure de communication produit soi-même un signal (Te) numérique de test et
- le dispositif (250) de contrôle interne à l'appareil injecte, après un lancement d'un mode de test, le signal numérique de test, comme signal de mesure, dans le dispositif (220) d'exploitation, pour tester l'appareil (200) sur site, dans lequel
- des enregistrements de valeur de perturbation extérieurs sont transmis au dispositif (250) de contrôle, par l'interface (230) extérieure de communication et
- le dispositif (250) de contrôle interne à l'appareil produit, avec les enregistrements de valeur de perturbation, les signaux (Te) numériques de test, en formant, avec les données de l'enregistrement de valeur de perturbation extérieur, des valeurs numériques d'échantillonnage, qui correspondent aux données d'au moins un convertisseur, reçues pendant l'enregistrement de valeur de perturbation et en tire parti pour tester l'appareil sur site et
- le dispositif (250) de contrôle interne à l'appareil met ensuite, lorsqu'il effectue le mode de test, en mémoire, sous la forme d'un écrit de perturbation, le signal de test appliqué au dispositif (230) d'exploitation, ainsi que la réaction correspondante de l'appareil sur site.

2. Appareil (200, 310, 320) sur site, notamment appareil de protection d'une installation (300) électrotechnique à contrôler, comprenant
- une pluralité d'entrées (E200a, E200b, E200,c) analogiques pour injecter un signal (Ma1, Ma2, Ma3, Ma4, Ma5, Ma6) analogique de mesure, qui se rapporte à l'installation technique à contrôler,
- une première interface (230) extérieure de communication pour injecter des signaux numériques de mesure et
- un dispositif (220) d'exploitation travaillant de manière numérique, qui est en liaison avec les entrées analogiques, respectivement, par une unité (210) de convertisseur A/N, et, respectivement, des entrées (S220) numériques de signal et avec l'interface (230) extérieure de communication, et qui, si un signal de mesure analogique du côté de l'entrée est appliqué, l'exploite et produit un signal (F) de défaut, si le signal de mesure indique un défaut de l'installation électrotechnique à contrôler, dans lequel
- l'appareil sur site a un dispositif (250) de contrôle interne à l'appareil, qui est en liaison avec le dispositif (220) d'exploitation d'une part et avec l'interface (230) extérieure de communication d'autre part, et qui est propre
- à produire soi-même un signal (Te) numérique de test et,
- après un lancement d'un mode de test, à injecter le signal numérique de test, comme signal de mesure, dans le dispositif (220) d'exploitation, pour tester l'appareil sur site, le dispositif (250) de contrôle interne à l'appareil étant propre à charger un enregistrement extérieur de valeur de perturbation et à former avec celui-ci le signal numérique de test ou à continuer à utiliser l'enregistrement de valeur de perturbation chargé, directement comme signal numérique de test, en conformant le dispositif (250) de contrôle interne à l'appareil, de manière à ce qu'il forme, avec les données de l'enregistrement de valeur de perturbation extérieur, des valeurs numériques d'échantillonnage, qui correspondent à des données d'au moins un convertisseur reçu pendant l'enregistrement de valeur de perturbation et à ce qu'il en tire parti pour le test de l'appareil sur site, dans lequel
- le dispositif (250) de contrôle interne à l'appareil est conformé de manière à mettre, lorsqu'il effectue le mode de test, en mémoire ensuite, sous la forme d'un écrit de perturbation, le signal de test appliqué au dispositif (230) d'exploitation, ainsi que la réaction correspondante de l'appareil sur site.

3. Appareil sur site suivant la revendication 2,
**caractérisé en ce que**
- l'appareil sur site a une entrée (230) de déclenchement en liaison avec le dispositif (250) de contrôle interne à l'appareil,
- dans lequel le dispositif (250) de contrôle est conformé de manière à lancer le mode de test pour tester l'appareil sur site, lorsqu'un signal de déclenchement est appliqué à l'entrée de déclenchement.

4. Appareil sur site suivant l'une des revendications 2 ou 3 précédentes,
**caractérisé en ce que**
le dispositif (250) de contrôle interne à l'appareil est propre à traiter un enregistrement de valeur de perturbation d'un convertisseur analogique ayant des données de convertisseur analogiques et à en former le signal numérique de test.

5. Appareil sur site suivant l'une des revendications 2 à 4 précédentes,
**caractérisé en ce que**
le dispositif (250) de contrôle interne à l'appareil est propre à continuer à traiter un enregistrement de valeur de perturbation extérieur présent dans le format Comtrade.

6. Appareil sur site suivant l'une des revendications 2 à 5 précédentes,
**caractérisé en ce que**
le dispositif (250) de contrôle inter à l'appareil est conformé de manière
- à incorporer le signal numérique de test dans des paquets de données numériques compatibles au réseau et
- à transmettre les paquets de données numériques compatibles au réseau, par un réseau (240) interne à l'appareil, à une interface, interne à l'appareil et compatible au réseau, du dispositif d'exploitation.

7. Appareil sur site suivant la revendication 6,
**caractérisé en ce que**
le réseau (240) interne à l'appareil est formé par un réseau compatible à l'Ethernet ou par un bus de données suivant la norme SPI ou CAN.

8. Appareil sur site suivant l'une des revendications 3 à 7 précédentes,
**caractérisé en ce que**
le dispositif (250) de contrôle interne à l'appareil est conformé de manière à continuer à traiter, comme signal de déclenchement, un signal de temps d'horloge, en lançant le mode de test à un instant défini par le signal de temps d'horloge.

9. Appareil sur site suivant l'une des revendications 3 à 8 précédentes,
**caractérisé en ce que**
l'interface (230) extérieur de communication est un accès au réseau et l'entrée de déclenchement est formée par l'interface (230) extérieure de communication.

10. Appareil sur site suivant l'une des revendications 2 à 9 précédentes,
**caractérisé en ce que**
- le dispositif (230) d'exploitation a plusieurs entrées (S200) numériques de signal et
- **en ce que**, peut être chargé dans le dispositif (250) de contrôle interne à l'appareil, un fichier de configuration, qui fixe l'entrée (S200) numérique du signal du dispositif (230) d'exploitation où le signal numérique de test doit être appliqué par le dispositif (250) de contrôle.

11. Appareil sur site suivant la revendication 10, **caractérisé en ce que**
- le dispositif (250) de contrôle interne à l'appareil est conformé de manière à pouvoir appliquer plusieurs signaux numériques de test en même temps au dispositif (230) d'exploitation,
- dans lequel il peut être fixé par le fichier de configuration comment l'association des signaux de test aux entrées (S200) du signal du dispositif (230) d'exploitation doit s'effectuer.

12. Appareil sur site suivant l'une des revendications 2 à 11 précédentes,
**caractérisé en ce que**
le dispositif (250) de contrôle interne à l'appareil est conformé, de manière à injecter dans le dispositif (230) d'exploitation, afin de tester l'appareil sur site, un signal numérique de test de manière répétée, notamment répétée périodiquement.

13. Appareil sur site suivant la revendication 12,
**caractérisé en ce que**
le dispositif (250) de contrôle interne à l'appareil est conformé de manière à utiliser, dans le cas d'une injection répétée du signal numérique de test, des facteurs de mise à l'échelle différents.

14. Appareil sur site suivant l'une des revendications 2 à 13 précédentes,
**caractérisé en ce que**
- l'appareil sur site a une sortie de signal de défaut réalisée de manière à pouvoir être déconnectée, pour l'émission vers l'extérieur du signal de défaut et
- **en ce que** le dispositif (250) de contrôle interne à l'appareil est conformé de manière à arrêter ou désactiver la sortie du signal de défaut dans le cas du mode de test.

15. Appareil sur site suivant l'une des revendications 2 à 14 précédente,
**caractérisé en ce que**
- l'interface (230) extérieure de communication de l'appareil sur site forme une sortie de signal de défaut pour l'émission à l'extérieur du signal de défaut et
- **en ce que** le dispositif (250) d'exploitation est conformé de manière à produire, dans le cas du mode de test, sur l'interface (230) de communication, un signal de défaut codé, qui indique qu'un test est effectué.

16. Appareil sur site suivant la revendication 1, dans lequel on teste un agencement d'appareils sur site, comprenant au moins deux appareils (310, 320) sur site, constitués suivant l'une des revendications 2 à 5 précédentes,
**caractérisé en ce que**
l'on teste, de manière synchronisée, les appareils sur site de l'agencement d'appareils sur site.

17. Appareil sur site suivant la revendication 16,
**caractérisé en ce que**
l'on applique à chacun des appareils sur site, respectivement, un signal (Tr1, Tr2) de déclenchement, de manière à ce que les appareils sur site exécutent, d'une manière corrélée entre eux dans le temps, leur mode de test respectif.

18. Appareil sur site suivant l'une des revendications 16 ou 17,
**caractérisé en ce que**
l'on injecte, dans au moins l'un des appareils sur site, un signal de sortie d'un autre appareil sur site.

19. Appareil sur site suivant la revendication 18,
**caractérisé en ce qu'**
au moins un appareil sur site continue à utiliser le signal de sortie de l'autre appareil sur site, comme signal numérique de test, ou en forme son signal numérique de test.

20. Appareil sur site suivant la revendication 18 ou 19,
**caractérisé en ce que**
le au moins un appareil sur site continue à utiliser le signal de sortie de l'autre appareil sur site, comme signal de déclenchement, ou en forme son signal de déclenchement.
